# EUROPEAN PATENT SPECIFICATION

(11) **EP 3 540 785 B1**
(45) Date of publication and mention of the grant of the patent: **22.09.2021**
(21) Application number: 17867659.9
(22) Date of filing: 31.10.2017
(51) Int. Cl.: H01L 31/0216, H01L 31/0747, H01L 31/068, H01L 31/05, H01L 31/18

(54) **METHOD FOR MANUFACTURING A SOLAR CELL**
VERFAHREN ZUR HERSTELLUNG EINER SOLARZELLE
PROCÉDÉ DE FABRICATION D'UNE CELLULE SOLAIRE

(30) Priority: 02.11.2016 JP 2016215562
(43) Date of publication of application: 18.09.2019
(73) Proprietor: Kaneka Corporation, Osaka-shi, Osaka 530-8288 (JP)
(72) Inventor: YOSHIKAWA, Kunta, Settsu-shi Osaka 566-0072 (JP)
(74) Representative: Nederlandsch Octrooibureau
(86) International application number: PCT/JP2017/039455
(87) International publication number: WO 2018/084159

(56) References cited:
- WO-A1-2014/192408
- WO-A2-2015/039128
- JP-A- H10 229 211
- JP-A- H10 229 211
- JP-A- 2011 211 199
- JP-A- 2013 062 308
- US-A- 3 350 775
- US-A1- 2013 139 871

## Description

### TECHNICAL FIELD

The present invention relates to a method for manufacturing a solar cell.

### BACKGROUND ART

In a solar cell using a crystalline silicon substrate, power is generated by extracting photoinduced carriers (electrons and holes) in crystalline silicon to an external circuit. The power per solar cell using a crystalline silicon substrate is at most about several watts. Thus, a solar cell string in which a plurality of solar cells are electrically connected in series through a wiring member is formed, and the voltages of the respective solar cells are added to increase the power.

A string in which a plurality of solar cells are connected in series suffers from electrical loss caused by the resistance of the wiring member. As the area of one solar cell increases, the current amount becomes larger, resulting in an increase in electric loss caused by the resistance of the wiring member. Patent Document 1 discloses a solar cell module in which solar cells each obtained by dividing a silicon substrate into two parts, so that the solar cell has an area equal to half the area before the silicon substrate is divided, are connected by a wiring member. When the area of the solar cell is halved, the current is halved, so that loss caused by the resistance of the wiring member can be reduced.

Patent Document 2 discloses a solar cell obtained by forming an insulating thin-film on a principal surface of a silicon substrate, and then dividing the substrate into two parts. The rectangular solar cell after the division has two lateral surfaces along the long side of the rectangle, one of which has been existing before the division, and the other of which is formed by the division. An insulating thin-film covers the former lateral surface, whereas crystalline silicon is exposed on the latter lateral surface.

### PRIOR ART DOCUMENTS

### PATENT DOCUMENTS

Patent Document 1: Japanese Patent Laid-open Publication No. 2012-256728
Patent Document 2: WO 2012/043770

US 3 350 775 A relates to photovoltaic devices such as solar cells and a process of making them.

US 2013/139871 A1 relates to a solar cell module and a method of manufacturing a solar cell module.

JP H10 229 211 A relates to a crystalline silicon photoelectric conversion device.

### SUMMARY OF THE INVENTION

### PROBLEMS TO BE SOLVED BY THE INVENTION

The inventors measured the characteristics of a solar cell obtained by dividing a substrate into two parts as disclosed in Patent Document 1 or Patent Document 2, and the results showed that the fill factor decreased as compared to that of the solar cell before the division. The invention is defined in claim 1. An object of the present invention is to provide a solar cell maintaining high power even after a substrate is divided, and to provide a solar cell module in which a plurality of such solar cells are electrically connected.

### MEANS FOR SOLVING THE PROBLEMS

When a lateral surface of a silicon substrate, which is formed at the time of dividing the silicon substrate, is covered with an oxide film, a passivation effect is obtained to provide a solar cell having characteristics equal to or higher than those before the division.

The solar cell of the present disclosure includes a rectangular crystalline silicon substrate. The rectangular crystalline silicon substrate has a rectangular first principal surface, a rectangular second principal surface positioned on a side opposite to the first principal surface, a first lateral surface connecting a long side of the first principal surface and a long side of the second principal surface, and a second lateral surface positioned on a side opposite to the first lateral surface and connecting the long side of the first principal surface and the long side of the second principal surface. At least one of the first principal surface and the second principal surface is covered with a thin-film. Examples of the thin-film that covers the principal surface of the silicon substrate include silicon-based thin-films and insulating material thin-films.

At least one of the thin-film that covers the first principal surface and the thin-film that covers the second principal surface is formed extended onto the first lateral surface. Thus, the first lateral surface is covered with a thin-film. Neither the thin-film that covers the first principal surface nor the thin-film that covers the second principal surface is extended to the second lateral surface. Thus, the second lateral surface is not covered with the thin-film covering the principal surface. On the second lateral surface, an oxide film of silicon is formed over the whole thickness direction of the crystalline silicon substrate.

By forming a thin-film on the principal surface of a square crystalline silicon substrate, and then dividing the silicon substrate, two rectangular crystalline silicon substrates are obtained. When a deposition of a thin-film on the crystalline silicon substrate is performed such that the thin-film is formed not only to the principal surface but also formed extended onto lateral surfaces of the square crystalline silicon substrate, the first lateral surface is covered with a thin-film even in the divided rectangular crystalline silicon substrate. The second lateral surface is a lateral surface formed by dividing the silicon substrate. Thus, even when lateral surfaces of the square silicon substrate is covered with a thin-film, the second lateral surface of the rectangular silicon substrate is not covered with the thin-film formed on the principal surface of the silicon substrate.

The oxide film on the second lateral surface is formed by exposing crystalline silicon exposed on the second lateral surface to an oxidizing atmosphere, which is an atmosphere having stronger oxidizing power than air at normal temperature. Accordingly, the silicon oxide film on the second lateral surface is a non-natural oxide film, and has a thickness larger than that of a natural oxide film of silicon.

By irradiating the square crystalline silicon substrate with laser light along the center line of the substrate to form a splitting groove, and then bending and splitting the crystalline silicon substrate along the splitting groove, the square crystalline silicon substrate can be divided into two rectangular crystalline silicon substrates. The irradiation of laser light may form an oxide film of silicon in a splitting groove-formed region on the second lateral surface. On a cut surface formed by bending and splitting the silicon substrate, crystalline silicon is exposed. An oxide film can be formed by exposing the exposed surface of crystalline silicon to an oxidizing atmosphere. The heating temperature in heating performed under an oxidizing atmosphere is from 100 to 200°C.

The oxide film formed on the surface of the splitting groove by irradiation of laser light has a thickness smaller than that of an oxide film formed by heating at about 100 to 200°C. Thus, the thickness of the oxide film on the second lateral surface of the silicon substrate on a side close to the first principal surface may be different from the thickness of the oxide film on a side close to the second principal surface.

Further, the present disclosure relates to a solar cell module including a solar cell string in which a plurality of solar cells as described above are connected by a wiring member. The solar cell module includes a solar cell string, an encapsulant which encapsulates the solar cell string, a light-receiving-surface protection member disposed on the encapsulant on the light-receiving side, and a back-surface protection member disposed on the encapsulant on the back side.

In one embodiment, the wiring member is arranged so as to extend parallel to the short side of the rectangle of the rectangular solar cell. In this embodiment, the solar cell string has a plurality of rectangular solar cells connected through a wiring member in such a manner that the rectangular solar cells are arranged along the short side direction of the rectangle.

### EFFECTS OF THE INVENTION

The solar cell of the present disclosure has a rectangular shape, and has an area half the area of a solar cell including a general square silicon substrate. Since the current of the solar cell is small, and the current passing through a wiring member connecting a plurality of solar cells is small, electrical loss caused by the resistance of the wiring member is small. On a lateral surface formed by dividing the silicon substrate, an oxide film is formed to bring about a passivation effect on the silicon substrate. Thus, as compared to a case where crystalline silicon is exposed on a lateral surface of a silicon substrate, the conversion characteristics of the solar cell are improved.

### BRIEF DESCRIPTION OF THE DRAWINGS

FIG. 1 is a sectional view of a solar cell of one embodiment.
FIG. 2A is a plan view of a solar cell string.
FIG. 2B is a sectional view of the solar cell string.
FIG. 3A is a plan view of the solar cell before division.
FIG. 3B is a sectional view of the solar cell before division.
FIG. 4A is a schematic sectional view of a solar cell in which a splitting groove is formed on a silicon substrate.
FIG. 4B is a schematic sectional view of the solar cell divided into two parts along the splitting groove.
FIG. 5 is a TEM image of a cross-section of a crystalline silicon substrate with a natural oxide film formed on a surface thereof.
FIG. 6 is a TEM image of a cross-section of a crystalline silicon substrate with an oxide film formed on a surface thereof by oxidation in an ozone-containing atmosphere.
FIG. 7 is a sectional view of a solar cell module.
FIG. 8 is a sectional view of a solar cell of one embodiment.
FIG. 9 is a sectional view of a solar cell of one embodiment.

### MODE FOR CARRYING OUT THE INVENTION

### [Configuration of solar cell]

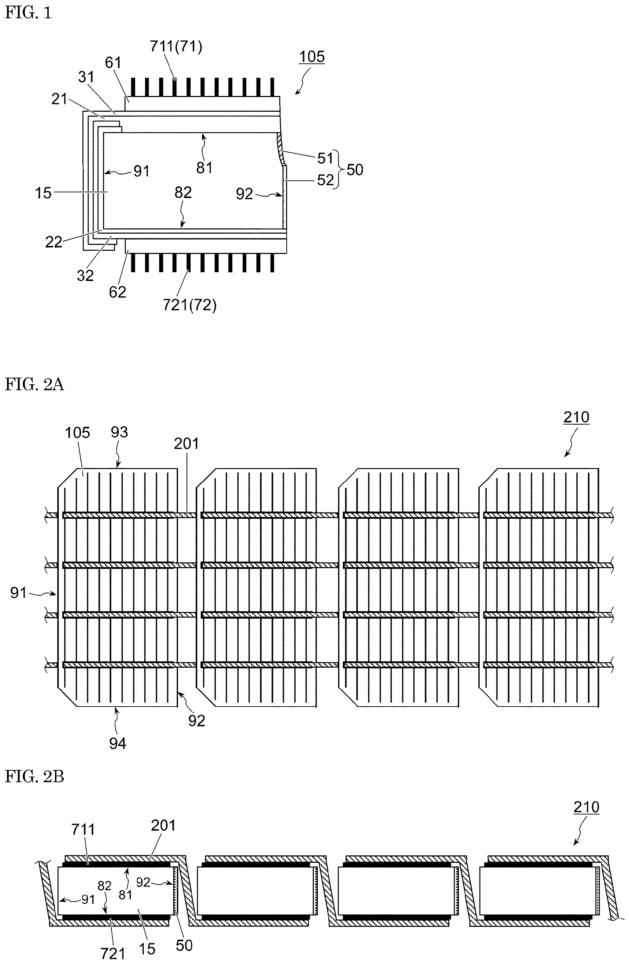

FIG. 1 is a schematic sectional view showing a solar cell according to one embodiment of the present disclosure.

FIG. 2A is a plan view of a solar cell string in which a plurality of solar cells are electrically connected through a wiring member, and FIG. 2B is a sectional view of the solar cell string.

As shown in FIG. 2A, the solar cell of the present disclosure has a rectangular shape having two long sides and two short sides in plan view. A solar cell 105 includes a crystalline silicon substrate 15 having a rectangular shape in plan view. The crystalline silicon substrate may be a single-crystalline silicon substrate or a polycrystalline silicon substrate. The silicon substrate 15 has a rectangular first principal surface 81 and a rectangular second principal surface 82. The second principal surface 82 is positioned on a side opposite to the first principal surface 81, one of the principal surfaces is a light-receiving surface, and the other is the back surface of the solar cell. In the description below, the first principal surface 81 is a light-receiving surface.

The silicon substrate 15 has a first lateral surface 91, a second lateral surface 92, a third lateral surface 93 and a fourth lateral surface 94. The first lateral surface 91 and the second lateral surface 92 are lateral surfaces connecting the long side of the first principal surface 81 and the long side of the second principal surface 82. The first lateral surface 91 and the second lateral surface 92 are positioned on opposite sides. The third lateral surface 93 and the fourth lateral surface 94 are lateral surfaces connecting the short side of the first principal surface and the short side of the second principal surface. The third lateral surface 93 and the fourth lateral surface 94 are positioned on opposite side.

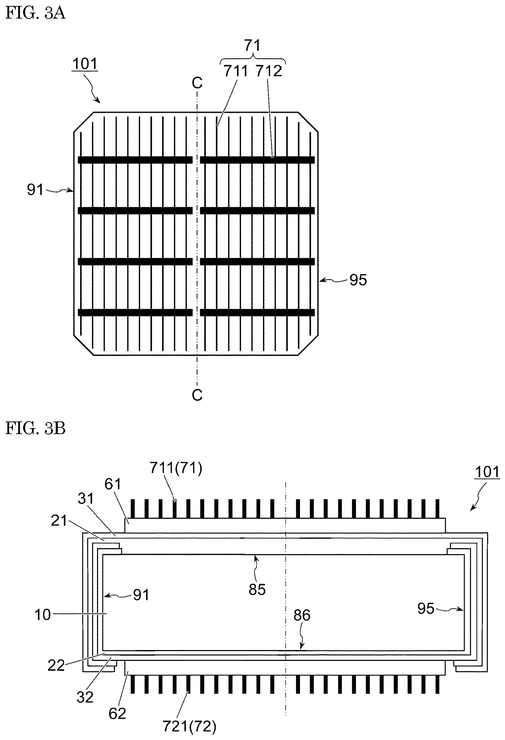

According to the present invention a rectangular solar cell is obtained by dividing a solar cell prepared using a square silicon substrate into two parts at the center. FIG. 3A is a plan view of the solar cell before division as seen from the first principal surface side. The square solar cell is not required to have a perfectly square shape, and may have, for example, a semi-square shape (a square shape having four rounded corners or having a notched portion) as shown in FIG. 3A. Similarly, a rectangular solar cell 105 may have rounded corners, or a notched portion as shown in FIG. 2A. The length of the long side of the rectangle is equal to the length of one side of the silicon substrate before division, and is about 100 to 200 mm. The length of the short side of the rectangle is substantially 1/2 of the length of the long side, and is about 50 to 100 mm.

In the rectangular solar cell 105, the first lateral surface 91 of the silicon substrate 15 is identical to the lateral surface 91 of the silicon substrate 10 in the solar cell 101 before division. The second lateral surface 92 is a surface (dividing surface) newly formed by dividing the square silicon substrate 10 into two parts.

In the solar cell manufacturing method of the present invention, at least one of the first principal surface 81 and the second principal surface 82 is covered with a thin-film, and the thin-film covering the principal surface of the silicon substrate 15 is formed extended to cover the first lateral surface 91. The thin-film covering the principal surface does not cover the second lateral surface 92, and an oxide film 50 is formed on the second lateral surface 92.

Hereinafter, configurations of thin-films and electrodes disposed on principal surfaces and lateral surfaces of the silicon substrate will be described with reference to a solar cell before division as shown in FIG. 3A and FIG. 3B.

FIG. 3B is a sectional view of the solar cell before division as shown in FIG. 3A. The solar cell 101 is a heterojunction solar cell in which a silicon-based thin-film of amorphous silicon or the like is disposed on the crystalline silicon substrate 10 having a square shape in front view. On the first principal surface 85 of the crystalline silicon substrate 10, a first intrinsic silicon-based thin-film 21, a first conductive silicon-based thin-film 31 and a first transparent electroconductive layer 61 are disposed. On the second principal surface 86 of the crystalline silicon substrate 10, a second intrinsic silicon-based thin-film 22, a second conductive silicon-based thin-film 32, and a second transparent electroconductive layer 62 are disposed. A metal electrode 71 and a metal electrode 72 are disposed on the first transparent electroconductive layer 61 and the second transparent electroconductive layer 62, respectively.

In the heterojunction solar cell, a single-crystalline silicon substrate of first conductivity-type is used as the crystalline silicon substrate 10. The "first conductivity-type" means one of an n-type and a p-type. From the viewpoint of improving light utilization efficiency by light confinement, it is preferable that the silicon substrate 10 has irregularity structures on a surface thereof. For example, pyramid-shaped irregularity structures are formed on a surface of a single-crystalline silicon substrate by anisotropic etching using an alkali.

Examples of the intrinsic silicon-based thin-films 21 and 22 and conductive silicon-based thin-films 31 and 32 include amorphous silicon-based thin-films and microcrystalline silicon-based thin-films (thin-films containing amorphous silicon and crystalline silicon). Among them, amorphous silicon-based thin-films are preferable. The intrinsic silicon-based thin-films 21 and 22 are preferably intrinsic amorphous silicon thin-films including silicon and hydrogen. By depositing amorphous silicon on a single-crystalline silicon substrate, surface passivation can be effectively performed while diffusion of impurities to the silicon substrate is suppressed. The first conductive silicon-based thin-film 31 and the second conductive silicon-based thin-film 32 have different conductivity-types. That is, one of the conductive silicon-based thin-films 31 and 32 is a p-type silicon-based thin-film, and the other is an n-type silicon-based thin-film.

A plasma CVD method is preferable as a method for forming such a silicon-based thin-film. When a thin-film is deposited on one principal surface of a silicon substrate by a dry process such as a CVD method, a sputtering method, a vacuum vapor deposition method, an ion plating method or the like without using a mask, a thin-film is deposited wraparound onto lateral surfaces of the silicon substrate and a principal surface on an opposite side. That is, as shown in FIG. 3B, the silicon-based thin-films 21 and 31 deposited on the first principal surface 85 of the silicon substrate 10 are not only formed on the first principal surface 85 but also formed on the lateral surfaces 91 and 95 and the peripheral portion of the second principal surface 86 by wraparound. The silicon-based thin-films 22 and 32 deposited on the second principal surface 86 of the silicon substrate 10 are formed not only on the second principal surface 86 but also on the lateral surfaces 91 and 95 and the peripheral portion of the first principal surface 85. Since the intrinsic silicon-based thin-film is disposed on the lateral surfaces by wraparound, as well as on the principal surface of the silicon substrate, a passivation effect on the silicon substrate is enhanced.

The transparent electroconductive layers 61 and 62 disposed on the silicon-based thin-film are composed of a conductive oxide such as ITO, and can be formed by a MOCVD method, a sputtering method, an ion plating method or the like. When a film is deposited while the peripheral portions of the principal surfaces 85 and 86 of the silicon substrate are covered with a mask, transparent electroconductive layers 61 and 62 are not formed on the peripheral portions of the principal surfaces 85 and 86 of the silicon substrate, and are not formed extended onto lateral surface and an opposite surface does not occur as shown in FIG. 3B. When a transparent electroconductive layer is deposited using a mask is used, it is possible to prevent a short-circuit of the front and back electroconductive layers due to wraparound deposition of the transparent electroconductive layer. Even when a mask is used in one of deposition of the transparent electroconductive layer 61 on the first principal surface 85 and deposition of the transparent electroconductive layer 62 on the second principal surface 86, a short-circuit of the front and back electroconductive layers can be prevented.

A metal electrode is disposed on each of the transparent electroconductive layers 61 and 62. The metal electrode disposed on the first principal surface, which is a light-receiving surface, is patterned. In the configuration shown in FIG. 3B, a patterned metal electrode is disposed on each of both surfaces. FIG. 3A shows a grid-shaped metal electrode 71 including a finger electrode 711 extending in one direction (y direction) and a bus bar electrode 712 orthogonal to the finger electrode. Such a patterned metal electrode can be formed by, for example, an inkjet method, a screen printing method, a plating method or the like. The metal electrode 72 disposed on the back side may be patterned, or may be disposed on the entire surface on the transparent electroconductive layer.

As described above, all the lateral surfaces of the silicon substrate 10 are covered with a silicon-based thin-film in a square solar cell 101. A rectangular solar cell can be obtained by dividing the square solar cell 101 into two parts along center line C-C. In this embodiment, a metal electrode is formed on a square silicon substrate, and the silicon substrate is then divided to prepare a rectangular solar cell. The metal electrode may be formed after division of the substrate. In view of the efficiency of pattern printing and the like, it is preferable to divide the substrate after formation of the metal electrode.

The method for dividing the solar cell (silicon substrate) is not particularly limited. The solar cell can be divided along a groove by, for example, forming the groove along a dividing line, and bending and splitting the silicon substrate along the groove at the center.

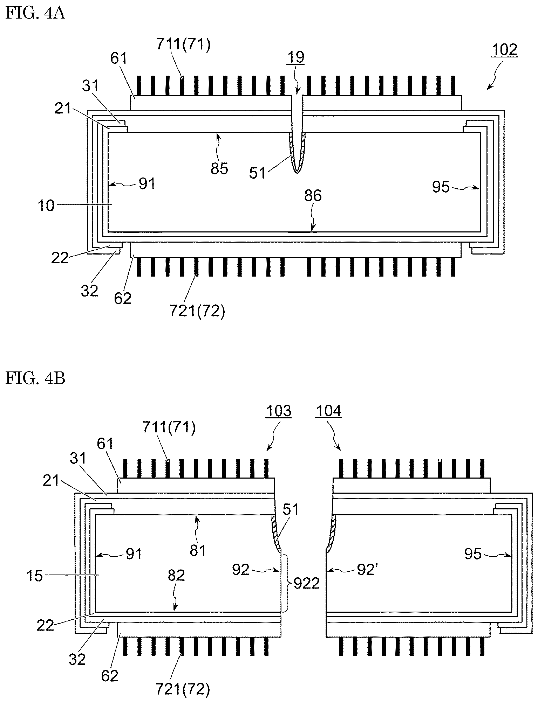

FIGS. 4A and 4B are diagrams schematically showing one example of a method in which a silicon substrate is cleaved by bending and splitting along a splitting groove 19 at the center to divide the silicon substrate. First, as shown in FIG. 4A, the splitting groove 19 is formed on the first principal surface of the solar cell. Although the method for forming a splitting groove is not particularly limited, laser light irradiation is preferable. As a laser for forming a splitting groove, one having power sufficient for formation of a groove at a wavelength of light that can be absorbed by the silicon substrate is applicable. For example, a UV laser having a wavelength of 400 nm or less, such as that of a third higher harmonic wave of a YAG laser or an Ar laser is preferable, and the laser power is preferably about 1 to 20 W The light diameter of laser light may be, for example, 20 to 200 µm. By applying laser light under such conditions, the splitting groove 19 having a width substantially equal to the diameter of laser light can be formed.

For example, the depth of the groove can be appropriately set such that the silicon substrate is easily split along the groove, and for example, the depth is set within a range of about 10% to 50% of the thickness of the silicon substrate 10. When the splitting groove 19 is formed by laser light irradiation in an oxygen-containing atmosphere such as air, a silicon oxide film 51 is formed on a surface of the splitting groove 19 on the silicon substrate 10. Although, in FIG. 4A, the splitting groove 19 is formed on the silicon substrate 10 on the first principal surface side, laser light irradiation may be performed from the second principal surface side to form a splitting groove on the second principal surface side.

By bending and splitting the silicon substrate 10 along the splitting groove 19 at the center, a solar cell 102 is divided into two parts: a solar cell 103 and a solar cell 104, as shown in FIG. 4B. Generally, the crystalline silicon substrate is cut out so as to have a predetermined orientation surface, and therefore when the splitting groove 19 serving as an origination point of cleavage is formed, the crystalline silicon substrate can be easily cleaved in a direction orthogonal to the substrate surface (cleaved along a thickness direction of the substrate).

The solar cell 103 after divided into two parts has a rectangular shape, and there are two lateral surfaces 91 and 92 along the long side of the rectangle and two lateral surfaces 93 and 94 along the short side of the rectangle. The first lateral surface 91 is a lateral surface which has been existing before division, and a silicon-based thin-film formed on the first principal surface and the second principal surface covers the first lateral surface. The third lateral surface 93 and the fourth lateral surface 94 are lateral surfaces obtained by dividing the lateral surface of the solar cell before division into two parts along center line C-C, and are covered with silicon-based thin-films deposited on the first principal surface and the second principal surface like the first lateral surface.

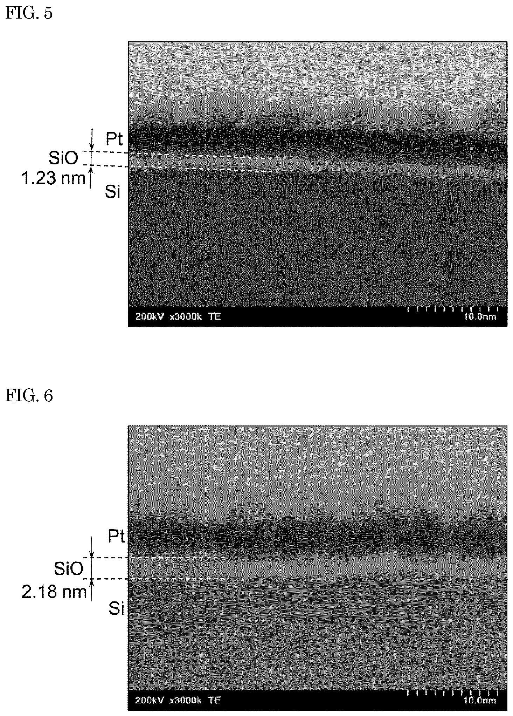

The second lateral surface 92 is a new surface formed by division, and is not covered with a thin-film, and on the second lateral surface, crystalline silicon is exposed. In a region where a splitting groove is formed by laser light irradiation, the oxide film 51 is formed by heating at the time of forming the groove. Crystalline silicon is exposed on a cut surface 922 formed by bending and splitting the substrate. On the cut surface 922 of crystalline silicon, a natural oxide film having a thickness of about 1 nm may be formed (see FIG. 5).

Silicon exposed on the cut surface 922 is exposed to an atmosphere having stronger oxidizing power than air at normal temperature to oxidize the cut surface, so that an oxide film 52 is formed on the cut surface as shown in FIG. 1. Thus, on the second lateral surface 92 of the silicon substrate 15 in the solar cell 105, the oxide film 50 including the oxide film 51 generated at the time of forming the splitting groove by the laser light and the oxide film 52 generated by oxidation after cleavage. In other words, on the second lateral surface 92 of the solar cell 105, the oxide film (non-natural oxide film) 50 formed under an oxidizing condition stronger than that of air at normal temperature exists over whole thickness direction.

The oxide film 52 is formed on the cut surface 922 of the silicon substrate in an oxidizing atmosphere. The oxidizing atmosphere means an oxidizing condition stronger than that of air at normal temperature, such as a gas atmosphere with high oxidizing power, a heating atmosphere, contact with an oxidizing solution, or the like. For example, a thermal oxide film is formed by performing heating in air. In addition, a chemical oxide film is formed by exposure to an oxidizing atmosphere in which ozone, hydrogen peroxide, high concentration oxygen or the like is present. Heating may be performed in an oxidizing gas atmosphere to form a chemical oxide film. In addition, a non-natural oxide film can be formed on the cut surface of the silicon substrate by performing local heating by laser irradiation or the like, spraying an oxidizing gas by air blowing, or the like. When heating is performed in air or an oxidizing gas atmosphere, the heating temperature is 100°C or higher. In order to suppress thermal degradation of the silicon-based thin-film or the transparent electroconductive layer, the heating temperature is 200°C or lower. When the lateral surface is locally heated by laser irradiation or the like, a region where the temperature is elevated by heating is limited, and therefore heat has small influences on the thin-film. Thus, the temperature of the local heating is not particularly limited. The spraying of the oxidizing gas by air blowing may also serve as an operation for removing debris generated in cleavage of the silicon substrate.

The oxide film 52 formed by heating or chemical oxidation generally has a thickness larger than that of a natural oxide film, and for example, an oxide film formed in a heating atmosphere at 150 to 200°C has a thickness of about 1.5 to 3 nm (see FIG. 6). The oxide film 51 formed by heat during laser irradiation has a thickness larger than that of the oxide film 52 formed by heating at 200°C or lower.

FIG. 5 is a transmission electron microscope (TEM) image of a cross-section of a silicon substrate having a natural oxide film, and FIG. 6 is a TEM image of a silicon substrate heated at 150°C for 1 hour in an atmosphere containing 100 ppm of ozone. In order to prevent collapse of the interface at the time of cutting, a platinum layer and a resin were stacked on a surface of the silicon substrate, and the silicon substrate was cut while the surface of the oxide film was protected, so that a sample for TEM observation was prepared. In the TEM image, the white region between silicon and a platinum layer is an oxide film. The thickness of the natural oxide film in FIG. 5 is 1.23 nm, whereas the thickness of the oxide film formed by heating in the ozone-containing atmosphere is 2.18 nm, and it is apparent that an oxide film having a thickness larger than that of the natural oxide film is formed.

When a silicon oxide film is formed by exposing a solar cell after division to an oxidizing atmosphere, a thin oxide film may be formed on a surface of the metal electrode 71. In particular, when heating is performed in the presence of an oxidizing gas such as ozone, an oxide film is easily formed on the surface of the metal electrode. When an oxide film is formed on the surface of the metal electrode, metallic luster is reduced to suppress light reflection, and therefore the metal electrode is hardly visible from outside, so that improvement of the visuality of the solar cell and the solar cell module can be expected. Since the thickness of the oxide film formed on the surface of the metal electrode is sufficiently small, influences of resistance by the oxide film hardly occur in connection of the wiring member (interconnector) onto the electrode.

When the square solar cell 101 is divided into two rectangular solar cells 103 and 104, the current density of the solar cell is substantially equal before and after division. Since the area of the solar cell after division is half the area before the division, the current amount per solar cell is about half of the current amount before the division. The sum of the current amounts of the two solar cells is substantially equal to the current amount of the solar cell before the division. Solar cells after division tend to have a fill factor lower than the fill factor before the division. Thus, the sum of the power of the rectangular solar cells 103 and 104 after division tends to be smaller than the power of the square solar cell 101 before the division.

By forming an oxide film on the silicon exposed surface of the second lateral surface 92 of the silicon substrate 15 after dividing the solar cell, the open circuit voltage and the fill factor of the solar cell tend to be improved, so that power equal to or higher than the power before the division is obtained. Thus, a solar cell module in which a plurality of the solar cells of the present disclosure are connected is excellent in power generation characteristics.

It is presumed that an increase in open circuit voltage and fill factor due to formation of an oxide film is related to the passivation effect on the silicon substrate. In the solar cell 101 before division, all principal surfaces and lateral surfaces are covered with a silicon-based thin-film, whereas in the solar cells 103 and 104 after division, the second lateral surfaces 92 and 92' are not covered with a thin-film, and silicon is exposed. Thus, it is considered that in the solar cells 103 and 104 before formation of the oxide film, the passivation effect on the silicon substrate is insufficient as compared to the solar cell 101 before the division, so that the carrier lifetime is decreased, leading to reduction of the open circuit voltage and the fill factor. On the other hand, it is considered that since silicon exposed on the second lateral surface of the silicon substrate 15 after division is covered with the oxide film 50 to recover the passivation effect, the solar cell 105 has an open circuit voltage and a fill factor which are equal to or higher than the open circuit voltage and the fill factor before the division. In order to improve the open circuit voltage and the fill factor of the solar cell, the thickness of the oxide film 52 formed on the cut surface 922 of the silicon substrate is preferably 1.5 nm or more, more preferably 1.8 nm or more, still more preferably 2 nm or more.

A plurality of rectangular solar cells 103 with the oxide film 50 formed on the second lateral surface 92 are electrically connected through a wiring member (interconnector) 201 to form a solar cell string 210. FIG. 2A shows a solar cell string in which rectangular solar cells are arranged side by side along a short side direction (x direction) and connected through the wiring member 201.

The grid-shaped metal electrode 71 of the solar cell 103 includes the finger electrode 711 extending in the long side direction (y direction) of the rectangle and the bus bar electrode 712 extending in the short side direction (x direction) of the rectangle. The wiring member 201 is arranged on the bus bar electrode 712, and as shown in FIG. 3B, the wiring member 201 connected to the first principal surface of the solar cell is connected to the second principal surface of the adjacent solar cell, whereby a plurality of solar cells are electrically connected in series. As the wiring member 201, for example, a belt-like thin plate composed of a metal such as copper is used. The wiring member can be connected to the electrode of the solar cell with solder, an electroconductive adhesive, an electroconductive film or the like interposed therebetween.

Since the area of one rectangular solar cell is half the area of the solar cell before division, the module voltage can be increased even when the solar cell module is installed at a spot having a small area. In addition, since the area of one solar cell is half the area of the solar cell before division, the current passing through the wiring member is halved, so that electrical loss caused by the resistance of the wiring member and power generation efficiency of the module can be increased.

A solar cell string in which the connection direction of solar cells is parallel to the short side direction of the rectangle as shown in FIG. 3A has the same number of wiring members and a half of the current amount as compared to a solar cell string formed using a square solar cell before division. Thus, the amount of current per wiring member is small, and electrical loss caused by resistance is reduced. In addition, since the oxide film 50 is formed on the lateral surface 92, leakage hardly occurs even when the wiring member 201 comes into contact with the silicon substrate.

In this embodiment, an oxide film is formed on the second lateral surface on which crystalline silicon is exposed by dividing the silicon substrate, and a solar cell string is then prepared. An oxide film may be formed on the second lateral surface of the silicon substrate after the rectangular solar cells after division are connected to the wiring member to prepare a string.

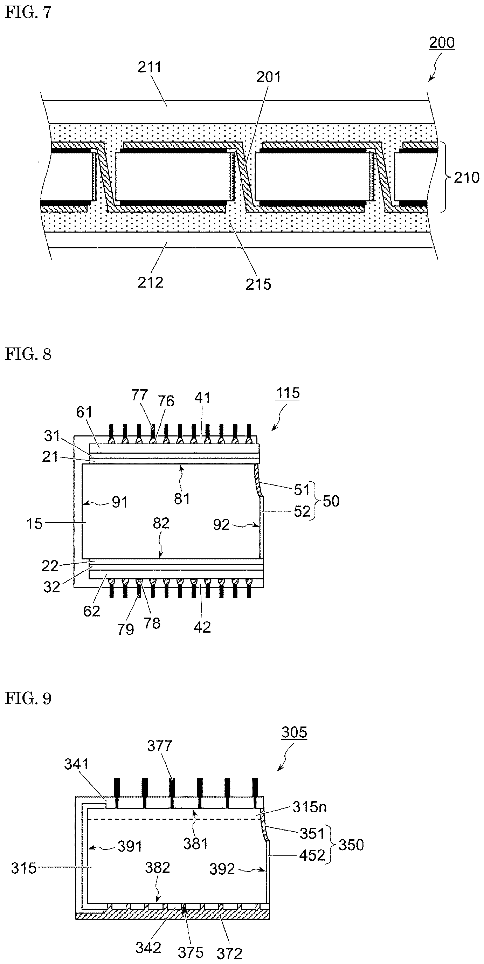

FIG. 7 is a sectional view of the solar cell module. A light-receiving-surface protection member 211 is arranged on the light-receiving side (upper side in FIG. 7) of the solar cell string 210 in which a plurality of solar cells are connected through the wiring member 201, and a back-surface protection member 212 is arranged on the back side (lower side in FIG. 7) of the solar cell string 210. In the module 200, an encapsulant 215 is filled between the protection members 211 and 212 to encapsulate the solar cell string 210.

Preferably, a transparent resin such as a polyethylene-based resin composition containing an olefin-based elastomer as a main component, polypropylene, an ethylene/α-olefin copolymer, an ethylene/vinyl acetate copolymer (EVA), an ethylene/vinyl acetate/triallyl isocyanurate (EVAT), polyvinyl butyrate (PVB), silicon, urethane, acrylic or epoxy is used as the encapsulant 215. The materials of the encapsulants on the light-receiving side and the back side may be the same or different.

The light-receiving-surface protection member 211 is light-transmissive, and glass, transparent plastic or the like is used as the light-receiving-surface protection member 211. The back-surface protection member 212 may be any of light-transmissive, light-absorptive and light-reflective. As the light-reflective back-surface protection member, one having a metallic color or white color is preferable, and a white resin film, a laminate with a metal foil of aluminum etc. sandwiched between resin films, or the like is preferably used. As the light-absorptive back-surface protection member, for example, one including a black resin layer is used.

An encapsulant and a protection member are disposed and stacked on each of the light-receiving side and the back side of the solar cell string 210, and in this state, vacuum lamination is performed to bring the encapsulant into close contact with the solar cell string and the protection member, followed by performing heating and press-bonding, whereby the encapsulant flows between solar cells and to the ends of the module to perform modularization.

In this embodiment, an oxide film is formed on the second lateral surface on which silicon is exposed by dividing the silicon substrate, a solar cell string is then prepared, and encapsulated to prepare a solar cell module. An oxide film may be formed on the second lateral surface of the silicon substrate after the rectangular solar cells after division are connected to the wiring member to prepare a string. However, when encapsulation is performed for modularization, the lateral surface of the silicon substrate is covered with the encapsulant, so that an oxidizing gas cannot make an access. In addition, even when heating is performed after vacuum lamination for encapsulation, an oxidizing gas is not present in the vicinity of the lateral surface of the silicon substrate, and therefore no oxide film is formed on the lateral surface of the silicon substrate. Thus, it is necessary to form an oxide film on the lateral surface of the silicon substrate before encapsulation.

With reference to FIG. 1, an example of a heterojunction solar cell has been described above in which the first lateral surface 91 along the long side of the rectangle is covered with a silicon-based thin-film extending from the first principal surface 85 and the second principal surface 86. It is to be noted that the thin-film covering the first lateral surface is not limited to the silicon-based thin-film. For example, at least one of the transparent electroconductive layer 61 on the first principal surface and the transparent electroconductive layer 62 on the second principal surface may cover the first lateral surface of the silicon substrate.

In a solar cell 115 shown in FIG. 8, an insulating material thin-film 41 disposed on the first principal surface 81 and an insulating material thin-film 42 disposed on the second principal surface cover the first lateral surface 91. Like the solar cell 105 shown in FIG. 1, the solar cell 115 has the silicon oxide film 50 disposed on the second lateral surface.

In this embodiment, an electroconductive seed 76 is disposed on the transparent electroconductive layer 61. The electroconductive seed is formed in the same pattern shape as that of the metal electrode. For example, when a grid-shaped metal electrode including a finger electrode and a bus bar electrode as shown in FIG. 3A is formed, the underlying electroconductive seed is formed in the same grid shape. The electroconductive seed can be formed by printing a metal paste, electroless plating, electroplating, photoplating, etc.

The insulating material thin-film 41 is formed so as to cover the transparent electroconductive layer 61 and the electroconductive seed 76. The insulating material may be an inorganic insulating material or an organic insulating material. An inorganic insulating material is preferable for imparting a passivation effect on the silicon substrate by the insulating material thin-film formed extended onto the first lateral surface. As the inorganic insulating material, silicon oxide, silicon nitride, silicon oxynitride, aluminum oxide, sialon (SiAlON), yttrium oxide, magnesium oxide, barium titanate, samarium oxide, barium tantalate, tantalum oxide, magnesium fluoride, titanium oxide, strontium titanate or the like is preferable. In particular, silicon-based insulating materials such as silicon oxide, silicon nitride, silicon oxynitride, aluminum oxide and sialon, and aluminum-based insulating materials are preferable for enhancing the passivation effect on the silicon substrate.

The insulating material thin-film 41 on the first principal surface 81 has an opening on the electroconductive seed 76, and the metal electrode 77 is in continuity with the electroconductive seed 76 through the opening. Examples of a method for forming an opening in the insulating material thin-film 41 include a method in which a mask is used at the time of forming a thin-film; and a method in which pattern etching is performed using a resist. In addition, as disclosed in WO 2013/077038, the electroconductive seed 76 may be formed using a metal paste, followed by depositing the insulating material thin-film 41, and forming an opening in the insulating material thin-film by means of thermal-fluidization of the electroconductive seed. When electroplating is performed with an opening formed in the insulating material thin-film on the electroconductive seed, a metal is selectively deposited on the electroconductive seed 76, so that a patterned metal electrode 77 is formed.

On the second principal surface 82 side, as in the case of the first principal surface 81, the insulating material thin-film 42 extending onto the first lateral surface 91 may be formed, and a plated metal electrode 79 may be formed on the electroconductive seed 78 through the opening of the insulating material thin-film 42.

In this embodiment, the insulating material thin-films 41 and 42 have a function as a pattern film in formation of a metal electrode by plating. The insulating material thin-films 41 and 42 also function as a barrier layer for protecting the transparent electroconductive layers 61 and 62 from a plating solution. Further, the insulating material thin-film extending from the first principal surface and the second principal surface and formed on the first lateral surface 91 has a passivation effect on the silicon substrate, and an effect as a barrier layer protecting the lateral surface of the silicon substrate from a plating solution.

In the configuration shown in FIG. 8, the insulating material thin-films 41 and 42 are formed on both surfaces of the silicon substrate, and both the insulating material thin-films are extending onto the first lateral surface 91. When an insulating material thin-film is deposited by a dry process, the insulating material thin-film extending onto lateral surfaces and a surface on a side opposite to the deposition surface. Thus, even when the insulating material thin-film is deposited only on one principal surface, the entire first lateral surface 91 is covered with the insulating material thin-film.

In addition to the insulating material thin-film in the embodiment described above, insulating material thin-films are formed on the surface of the silicon substrate for various purposes. For example, in a back contact-type solar cell having an electrode only on the back side, an insulating material thin-film is formed as a passivation film on the light-receiving side. The insulating material thin-film extending onto lateral surfaces of the silicon substrate, whereby a passivation effect on the lateral surfaces is obtained. In the PERC (Passivated Emitter and Rear Cell) solar cell, an insulating material thin-film as a passivation film is formed on the back surface of a silicon substrate for suppressing recombination at an interface between the back surface of the silicon substrate and a metal electrode.

For example, in the PERC solar cell schematically shown in FIG. 9, a passivation film 342 composed of silicon nitride, aluminum oxide or the like is disposed on the back surface of a silicon substrate, and a back surface electric field (AIBSF) 375 obtained by alloying aluminum and silicon by heating an aluminum film 372 is formed through an opening formed in the passivation film. On a light-receiving surface of a silicon substrate 315, a passivation film 341 is disposed. An Ag paste electrode is formed on the passivation film 341, and by a fire-through method, the passivation film 341 was pierced to bring the Ag paste electrode into contact with an n-type dopant diffusion region 315n of the silicon substrate 315.

In the solar cell 305, the passivation film 341 on the light-receiving surface and the passivation film 342 on the back surface are formed extended onto the first lateral surface 391. The passivation films 341 and 342 do not cover the second lateral surface 392 which is a cut surface. When in a solar cell having an insulating thin-film on a silicon substrate surface as described above, an oxide film 350 is formed on a silicon exposed surface of a second lateral surface 392 of the silicon substrate 315 after cleavage, the fill factor of the solar cell can be improved.

### EXAMPLES

Hereinafter, the present invention will be described in more detail by showing examples for manufacturing a PERC solar cell, but the present invention is not limited to the following examples.

### [Reference Example 1: Preparation of square solar cell]

A 6-inch p-type single-crystalline silicon substrate in which a pyramid-shaped texture having a height of about 2 µm was formed on a light-receiving surface by anisotropic etching using an alkali was subjected to phosphorus diffusion to diffuse phosphorus on both surfaces of the substrate. The back surface of the substrate was brought into contact with a liquid surface of a HF/HNO₃ aqueous solution, the back surface of the substrate was etched by about 5 µm, and phosphosilicate glass (PSG) generated on the back surface of the substrate during phosphorus diffusion and the phosphorus diffusion region were removed to obtain a smooth surface free from impurities such as phosphorus and glass. Thereafter, the substrate was immersed in an about 3% HF aqueous solution to remove the PSG on the light-receiving surface.

After the PSG was removed, the substrate was transferred to a CVD apparatus, and a 70 nm-thick silicon nitride layer was formed on the light-receiving surface. Next, on the back surface of the silicon substrate, a 40 nm-thick aluminum oxide layer and a 130 nm-thick silicon nitride layer were sequentially deposited as passivation films. The passivation film on the back surface was pulse-irradiated with a second higher harmonic wave (532 nm) of a YAG laser to form a contact opening having a diameter of 100 µm in a lattice shape with intervals of 1 mm.

An Ag paste was applied onto the silicon nitride layer on the light-receiving side by screen printing in a grid pattern consisting of bus bar electrodes and finger electrodes, and heated at 300°C for about 40 seconds. Thereafter, an Al paste was applied onto the entire surface of the silicon nitride layer on the back surface, and an Ag paste was applied by screen printing at a position corresponding to the bus bar on the light-receiving surface. The substrate was conveyed into a firing furnace with the light-receiving surface facing upward, and fired at about 900°C, so that the Ag paste on the light-receiving surface pierced the silicon nitride layer to come into contact with the phosphorus diffusion region of the silicon substrate. At the same time, Al reacted with the silicon substrate through the contact opening of the passivation film on the back side to form an aluminum back surface field (A1BSF) on the back surface of the silicon substrate.

### [Reference Example 2: Preparation of rectangular solar cell by cleaving silicon substrate]

The conversion characteristics of the solar cell obtained in Reference Example 1 were measured, and the solar cell was then irradiated with a third higher harmonic wave of a YAG laser (wavelength: 355 nm) from the light-receiving side to form a splitting groove along an in-plane center line in a direction parallel to the finger electrode. The depth of the splitting groove was about 1/3 of the thickness of the silicon substrate.

The silicon substrate was bent and split along the splitting groove to be divided into two rectangular solar cells. On the cut surface of the silicon substrate of the solar cell after division, neither an aluminum oxide layer nor a silicon nitride layer was formed, and thus crystalline silicon was exposed.

### [Example: Oxidation of lateral surface of silicon substrate]

The conversion characteristics of each of the two rectangular solar cells obtained in Reference Example 2 were measured, and heating was then performed in a heating oven at 150°C for 1 hour to form an oxide film on the exposed surface of crystalline silicon. Thereafter, the conversion characteristics of each of the two solar cells were measured.

### [Comparative Example: Vacuum heating of lateral surface of silicon substrate]

Instead of heating in an air atmosphere in the Example, heating was performed at 150°C in a vacuum oven, and the conversion characteristics of each of two solar cells were measured.

The conversion characteristics of the solar cells of Reference Examples 1 and 2, the Example and the Comparative Examples are shown in Table 1. The current Isc, the open circuit voltage Voc and the fill factor FF and the maximum power Pmax in Table 1 are each shown as a relative value where the measured value for the square solar cell of Reference Example 1 is 1. In Reference Example 2, the Example and the Eomparative Example, the maximum power of one rectangular solar cell (single cell) and the sum of the maximum power of two solar cells are shown.

**Table 1**

| | Isc | Voc | FF | Pmax | |
|---|---|---|---|---|---|
| | | | | single cell | sum |
| Reference Example 1 | 1 | 1 | 1 | 1 | 1 |
| Reference Example 2 | 0.504 | 0.997 | 0.992 | 0.498 | 0.994 |
| | 0.497 | 1.005 | 0.996 | 0.496 | |
| Example | 0.502 | 1.003 | 1.000 | 0.504 | 1.002 |
| | 0.495 | 1.006 | 1.000 | 0.498 | |
| Comparative Example | 0.503 | 1.000 | 0.995 | 0.500 | 0.996 |
| | 0.496 | 1.003 | 0.997 | 0.496 | |

Comparison between the square solar cell of Reference Example 1 and the rectangular solar cell of Reference Example 2 shows that there was substantially no difference in Voc, and the Isc in Reference Example 1 was substantially equal to the total Isc of two solar cells in Reference Example 2. However, in Reference Example 2, the FF was lower than the FF in Reference Example 1, and accordingly, the total Pmax of the two solar cells was reduced. On the other hand, in the Example in which heating was performed in an air atmosphere, the FF and the Voc were higher as compared to Reference Example 2, and the total Pmax of the two solar cells was higher than the Pmax in Reference Example 1. On the other hand, in the Comparative Example in which heating was performed under vacuum, evident improvement of the characteristics was not observed.

In the Comparative Example, improvement of the characteristics by heating was not observed, whereas in the Example, the Voc and the FF were improved, and this is ascribable to the oxide film formed on the cut surface of the silicon substrate by heating in an air atmosphere. These results show when a square solar cell is cleaved, and an oxide film is then formed on the cut surface by heating, it is possible to obtain a solar cell which is excellent in conversion characteristics and has reduced electrical loss when a plurality of solar cells are connected and modularized.

### DESCRIPTION OF REFERENCE CHARACTERS

- 10, 15: crystalline silicon substrate
- 81, 82, 85, 86: principal surface
- 91, 92, 95: lateral surface
- 21, 22, 31, 32: silicon-based thin-film
- 61, 62: transparent electroconductive layer
- 41,42: insulating material thin-film
- 71, 72: metal electrode
- 711: finger electrode
- 712: bus bar electrode
- 50, 51, 52: oxide film
- 105, 115: solar cell
- 200: solar cell module
- 201: wiring member
- 210: solar cell string
- 211, 212: protection member
- 215: encapsulant

## Claims

1. A method for manufacturing a solar cell (103, 104, 105) comprising a rectangular crystalline silicon substrate (15), the method comprising the steps of
depositing a thin-film on at least one of a first principal surface (85) and a second principal surface (86) of a square crystalline silicon substrate (10); and
dividing the square crystalline silicon substrate (10) provided with the thin-film into two rectangular crystalline silicon substrates (15),
wherein each rectangular crystalline silicon substrate (15) after division has a rectangular first principal surface (81), a rectangular second principal surface (82) positioned on a side opposite to the first principal surface (81), a first lateral surface (91, 95) connecting one long side of the first principal surface (81) and one long side of the second principal surface (82), and a second lateral surface (92, 92') positioned on a side opposite to the first lateral surface (91, 95) and connecting another long side of the first principal surface (81) and another long side of the second principal surface (82),
wherein in deposition of the thin-film, the thin-film is formed not only on the principal surface of the square crystalline silicon substrate (10), but also formed extended onto lateral surfaces of the square crystalline silicon substrate (10), thereby the first lateral surface (91, 95) of the rectangular crystalline silicon substrate (15) after division is covered with the thin-film, and the second lateral surface (92, 92') is not covered with the thin-film,
**characterized in that** the method further comprising heating the second lateral surface (92, 92') of the rectangular crystalline silicon substrate (15) at a temperature of 100 to 200°C in an oxidizing atmosphere to form an oxide film (50) on the crystalline silicon exposed on the second lateral surface (92, 92').

2. The method for manufacturing a solar cell according to claim 1, wherein the step of dividing the square crystalline silicon substrate into two rectangular crystalline silicon substrates includes:
irradiating the square crystalline silicon substrate with laser light along a center line of the crystalline silicon substrate to form a splitting groove (19); and
bending and splitting the square crystalline silicon substrate along the splitting groove.

3. The method for manufacturing a solar cell according to claim 2, wherein an oxide film of silicon (51) on a splitting groove-formed region of the second lateral surface is formed by an irradiation of the laser light.

4. The method for manufacturing a solar cell according to any one of claims 1 to 3, wherein a cut surface on which crystalline silicon is exposed is formed by bending and splitting the square crystalline silicon substrate, and crystalline silicon exposed on the cut surface is exposed to an oxidizing atmosphere to form the oxide film.

5. The method for manufacturing a solar cell according to any one of claims 1 to 4, wherein the thin-film covering the first lateral surface is a silicon-based thin-film.

6. The method for manufacturing a solar cell according to claim 5, wherein the silicon-based thin-film is disposed in contact with the first lateral surface of the square crystalline silicon substrate, and the silicon-based thin-film is an intrinsic amorphous silicon thin-film.

7. The method for manufacturing a solar cell according to any one of claims 1 to 4, wherein the thin-film covering the first lateral surface is an insulating material thin-film.

## Patentansprüche

1. Verfahren zur Herstellung einer Solarzelle (103, 104, 105), die ein rechteckiges kristallines Siliziumsubstrat (15) umfasst, wobei das Verfahren die folgenden Schritte umfasst:
Aufbringen eines dünnen Films auf einer ersten Hauptoberfläche (85) und/oder einer zweiten Hauptoberfläche (86) eines quadratischen kristallinen Siliziumsubstrats (10); und
Teilen des quadratischen kristallinen Siliziumsubstrats (10), das mit dem dünnen Film versehen ist, in zwei rechteckige kristalline Siliziumsubstrate (15),
wobei jedes rechteckige kristalline Siliziumsubstrat (15) nach dem Teilen eine rechteckige erste Hauptoberfläche (81), eine rechteckige zweite Hauptoberfläche (82), die an einer Seite entgegengesetzt zu der ersten Hauptoberfläche (81) positioniert ist, eine erste laterale Oberfläche (91, 95), die eine lange Seite der ersten Hauptoberfläche (81) und eine lange Seite der zweiten Hauptoberfläche (82) verbindet, und eine zweite laterale Oberfläche (92, 92') hat, die an einer Seite entgegengesetzt zu der ersten lateralen Oberfläche (91, 95) positioniert ist und eine andere lange Seite der ersten Hauptoberfläche (81) und eine andere lange Seite der zweiten Hauptoberfläche (82) verbindet,
wobei beim Aufbringen des dünnen Films der dünne Film nicht nur auf der Hauptoberfläche des quadratischen kristallinen Siliziumsubstrats (10) gebildet wird, sondern auch mit einer Erstreckung auf laterale Oberflächen des quadratischen kristallinen Siliziumsubstrats (10) gebildet wird, wodurch die erste laterale Oberfläche (91, 95) des rechteckigen kristallinen Siliziumsubstrats (15) nach dem Teilen mit dem dünnen Film bedeckt ist, und die zweite laterale Oberfläche (92, 92') nicht mit dem dünnen Film bedeckt ist,
**dadurch gekennzeichnet, dass**
das Verfahren ferner ein Heizen der zweiten lateralen Oberfläche (92, 92') des rechteckigen kristallinen Siliziumsubstrats (15) bei einer Temperatur von 100 bis 200° C in einer oxidierenden Atmosphäre umfasst, um einen Oxidfilm (50) auf dem kristallinen Silizium zu bilden, das an der zweiten lateralen Oberfläche (92, 92') exponiert ist.

2. Verfahren zur Herstellung einer Solarzelle nach Anspruch 1, wobei der Schritt des Teilens des quadratischen kristallinen Siliziumsubstrats in zwei rechteckige kristalline Siliziumsubstrate umfasst:
Bestrahlen des quadratischen kristallinen Siliziumsubstrats mit Laserlicht entlang einer zentralen Linie des kristallinen Siliziumsubstrats, um eine Spaltrille (19) zu bilden; und
Biegen und Spalten des quadratischen kristallinen Siliziumsubstrats entlang der Spaltrille.

3. Verfahren zur Herstellung einer Solarzelle nach Anspruch 2, wobei ein Oxidfilm von Silizium (51) auf einer spaltrillenförmigen Region der zweiten lateralen Oberfläche durch eine Bestrahlung des Laserlichts gebildet wird.

4. Verfahren zur Herstellung einer Solarzelle nach einem der Ansprüche 1 bis 3, wobei eine Schnittoberfläche, auf der kristallines Silizium exponiert ist, durch Biegen und Spalten des quadratischen kristallinen Siliziumsubstrats gebildet wird, und kristallines Silizium, das auf der Spaltoberfläche exponiert ist, einer oxidieren Atmosphäre ausgesetzt wird, um den Oxidfilm zu bilden.

5. Verfahren zur Herstellung einer Solarzelle nach einem der Ansprüche 1 bis 4, wobei der dünne Film, der die erste laterale Oberfläche bedeckt, ein dünner Film auf Siliziumbasis ist.

6. Verfahren zur Herstellung einer Solarzelle nach Anspruch 5, wobei der dünne Film auf Siliziumbasis in Kontakt mit der ersten lateralen Oberfläche des quadratischen kristallinen Siliziumsubstrats angeordnet ist, und der dünne Film auf Siliziumbasis ein intrinsischer amorpher Siliziumdünnfilm ist.

7. Verfahren zur Herstellung einer Solarzelle nach einem der Ansprüche 1 bis 4, wobei der dünne Film, der die erste laterale Oberfläche bedeckt, ein dünner Film aus isolierendem Material ist.

## Revendications

1. Procédé de fabrication d'une cellule solaire (103, 104, 105) comprenant un substrat de silicium cristallin rectangulaire (5), le procédé comprenant les étapes :
déposer une couche mince sur au moins une d'une première surface principale (85) et d'une seconde surface principale (86) d'un substrat de silicium cristallin carré (10) ; et
diviser le substrat de silicium cristallin carré (10) muni de la couche mince en deux substrats de silicium cristallin rectangulaires (15),
chaque substrat de silicium cristallin rectangulaire (15) après division ayant une première surface principale rectangulaire (81), une seconde surface principale rectangulaire (82) positionnée sur un côté opposé à la première surface principale (81), une première surface latérale (91, 95) reliant un côté long de la première surface principale (81) et un côté long de la seconde surface principale (82), et une seconde surface latérale (92, 92') positionnée sur un côté opposé à la première surface latérale (91, 95) et reliant un autre côté long de la première surface principale (81) et un autre côté long de la seconde surface principale (82),
lors du dépôt de la couche mince, la couche mince étant non seulement formée sur la surface principale du substrat de silicium cristallin carré (10), mais également formée de manière étendue sur les surfaces latérales du substrat de silicium cristallin carré (10), de telle sorte que la première surface latérale (91, 95) du substrat de silicium cristallin rectangulaire (15) après division est recouverte de la couche mince, et que la seconde surface latérale (92, 92') n'est pas recouverte de la couche mince,
**caractérisé par le fait que**
le procédé comprend en outre chauffer la seconde surface latérale (92, 92') du substrat de silicium cristallin rectangulaire (15) à une température de 100 à 200°C dans une atmosphère oxydante pour former un film d'oxyde (50) sur le silicium cristallin exposé sur la seconde surface latérale (92, 92').

2. Procédé de fabrication d'une cellule solaire selon la revendication 1, dans lequel l'étape de division du substrat de silicium cristallin carré en deux substrats de silicium cristallin rectangulaires comprend :
irradier le substrat de silicium cristallin carré avec de la lumière laser le long d'une ligne centrale du substrat de silicium cristallin pour former une rainure de séparation (19) ; et
plier et séparer le substrat de silicium cristallin carré le long de la rainure de séparation.

3. Procédé de fabrication d'une cellule solaire selon la revendication 2, dans lequel un film d'oxyde de silicium (51) sur une région, formée par la rainure de séparation, de la seconde surface latérale, est formé par une irradiation de la lumière laser.

4. Procédé de fabrication d'une cellule solaire selon l'une quelconque des revendications 1 à 3, dans lequel une surface découpée, sur laquelle du silicium cristallin est exposé, est formée par pliage et séparation du substrat de silicium cristallin carré, et du silicium cristallin exposé sur la surface découpée est exposé à une atmosphère oxydante pour former le film d'oxyde.

5. Procédé de fabrication d'une cellule solaire selon l'une quelconque des revendications 1 à 4, dans lequel la couche mince recouvrant la première surface latérale est une couche mince à base de silicium.

6. Procédé de fabrication d'une cellule solaire selon la revendication 5, dans lequel la couche mince à base de silicium est disposée en contact avec la première surface latérale du substrat de silicium cristallin carré, et la couche mince à base de silicium est une couche mince de silicium amorphe intrinsèque.

7. Procédé de fabrication d'une cellule solaire selon l'une quelconque des revendications 1 à 4, dans lequel la couche mince recouvrant la première surface latérale est une couche mince en matériau isolant.
